# DEMANDE DE BREVET EUROPEEN

(11) **EP 1 471 781 A1**
(43) Date de publication de la demande: **27.10.2004**
(21) Numéro de dépôt: 04291058.8
(22) Date de dépôt: 23.04.2004
(51) Int. Cl.: H05K 7/18

(54) **Baie modulable pour matériel informatique, électrique, électronique et/ou similaire**

(30) Priorité: 25.04.2003 FR 0305138
(71) Demandeur: Euro Baie Concept, 34990 Juvignac (FR)
(72) Inventeur: Amar, Didier Charles, 34990 JUVIGNAC (FR)
(74) Mandataire: Pontet, Bernard

(57) **Abrégé**

La baie selon l'invention, comprenant un bâti 1 supportant des parois et une porte, ledit bâti 1 comprenant notamment des traverses 5, 7 ; 6, 8 ; 9, 11 ;10, 12 définissant la profondeur de ladite baie, est caractérisée en ce que lesdites traverses sont télescopiques comportant des moyens 13, 14 pour les fixer dans une position télescopique choisie. La baie comprenant des étagères de profondeur également variable.

Avantage : la baie est modulable en profondeur.

## Description

La présente invention concerne une baie modulable pour matériel informatique, électrique, électronique et/ou similaire, ladite baie pouvant reposer par terre ou être suspendue à un mur.

Dans ce domaine, les dimensions en largeur des composants du matériel sont en général standard, normalisés, tandis que la profondeur de la baie dépend elle du type de matériel utilisé et de la place disponible à l'endroit où est installée ladite baie. Ainsi notamment, pour du matériel informatique (par exemple bandeaux de brassage, matériel actif du type «hub », « switch », serveur), la norme en largeur est actuellement de 19 pouces.

Jusqu'à ce jour, on propose à un client une gamme de baies de dimension en profondeur fixe et celui-ci choisit la baie la mieux adaptée au moment de sa première installation.

La présente invention a pour but de proposer une solution qui soit plus souple pour le client et qui permette de s'adapter quasiment sur mesure à un emplacement quelconque pour la baie, provisoire ou définitif.

Elle propose une baie modulable pour matériel informatique, électronique, électrique ou similaire comprenant un bâti parallélépipédique supportant au moins une paroi fermant tout ou partie de ses accès sur au moins un de ses faces, ledit bâti comprenant notamment des traverses définissant la profondeur de ladite baie, lesdites traverses étant télescopiques et comportant des moyens pour les fixer dans une position télescopique choisie définissant pour l'intérieur du bâti une profondeur dépendant de la position de cette traverse.

Ainsi, grâce à cette conception modulable en profondeur, l'installateur n'a plus à choisir approximativement une baie dans une gamme de baies s'approchant au mieux en profondeur de l'utilisation prévue de ladite baie. Un seul modèle de baie peut ainsi être vendu dont la profondeur est réglée avantageusement sur place au moment de l'installation. Ainsi, non seulement cela simplifie les opérations préalables de mesure et de commande de l'installateur, et également de gestion de ses stocks, mais également cela permet de mieux optimiser les emplacements pour les baies, sans retraits ou dépassements inutiles de la baie. En outre, la même baie peut le cas échéant être réutilisée par la suite pour une nouvelle destination de matériel et une nouvelle profondeur.

Chaque traverse de la baie selon l'invention comporte au moins deux parties télescopiques.

Selon un mode de réalisation possible, le bâti comprend un cadre inférieur et un cadre supérieur sur lesquels sont montés les quatre montants de la baie. Chaque cadre comporte deux parties en « U », les branches des « U » étant réunies deux à deux de façon coulissante pour former les traverses télescopiques selon l'invention.

Les moyens de fixation de la position télescopique choisie peuvent être notamment constitués de systèmes de trous coopérant avec des goupilles ou avec des cliquets rétractables formant des crans d'arrêt, des systèmes de frottement ménagés entres les parties télescopiques ou tout autre moyen adapté.

Selon un mode de réalisation possible, les parois de côté de la baie ont une largeur réglable. Ces parois peuvent par exemple être constituée chacune de deux panneaux pouvant se chevaucher.

De façon à permettre un accès facile au matériel installé dans la baie, au moins une des parois présente au moins une partie mobile réalisant une porte fermant un accès en une face de la baie.

Selon un autre mode de réalisation, le bâti comprend deux cadres constitués chacun de deux parties en « U » dont les branches en vis-à-vis sont adaptées à s'emboîter avec au moins un élément intermédiaire les réunissant pour former lesdites traverses télescopiques.

Pour permettre un meilleur positionnement des parois et présenter une surface plus uniforme et esthétique, un montant de bâti comprend une bande de montant portant des moyens de fixation ou d'accrochage d'une paroi ou d'une porte.

Un aspect uniforme et dénudé est obtenu par un positionnement des parois et des portes qui leur font masquer la majorité des moyens de fixation ou d'accrochage qui les fixent au bâti.

Pour une accès facile à l'intérieur depuis le côté de la baie, une paroi peut comprendre un panneau mobile pouvant coulisser sensiblement dans le plan de la paroi pour découvrir un accès à l'intérieur de la baie, grâce à des moyens de guidage portés par au moins une traverse.

Une installation simplifiée de matériel dans la baie est facilitée par des étagères en plusieurs deux parties pouvant se chevaucher ou s'emboîter et formant une étagère de profondeur variable.

D'autres particularités et avantages de l'invention ressortiront de la description détaillée d'un mode de mise en oeuvre nullement limitatif, et des dessins annexés sur lesquels :
- la figure 1 est une vue en perspective schématique montrant partiellement un mode de réalisation d'une baie où les cadres inférieur et supérieur s'emboîtent directement l'un dans l'autre ;
- la figure 2 illustre un mode de réalisation comprenant des parois latérales et supérieure coulissantes ainsi qu'une porte en façade et doté d'une étagère de profondeur variable, et où les cadres inférieur et supérieur sont reliés par un élément intermédiaire ;
- la figure 3 est une vue partielle en coupe de dessus d'un montant recevant une paroi et une échelle d'accrochage ;
- la figure 4 est une vue de côté illustrant une étagère à profondeur variable incluse dans une baie selon l'invention.

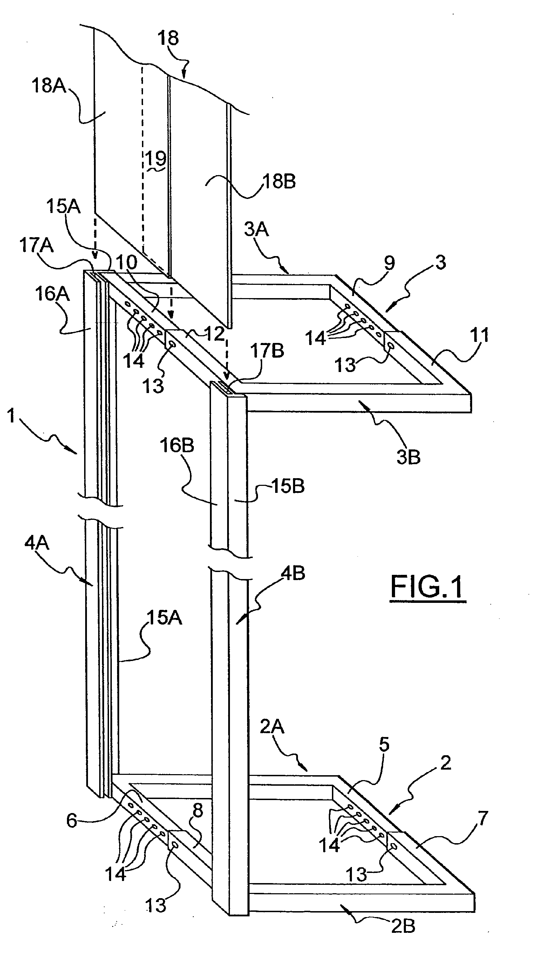

Sur la figure 1, est représenté partiellement le bâti 1 d'une baie selon un mode de réalisation de l'invention. Ce bâti 1 comprend deux cadres inférieur 2 et supérieur 3 et quatre montants, dont deux 4A et 4B seulement sont représentés sur la figure. Les cadres 2 et 3 sont similaire s ou identiques, constitués chacun de deux parties en « U », respectivement 2A, 2B et 3A, 3B dont les branches, identiques en largeur, sont adaptées à s'emboîter de manière à définir deux à deux une traverse de bâti télescopique. Ainsi, pour le cadre inférieur de bâti 2, la partie en « U » 2A a ses deux extrémités de branches 5 et 6 enfilées respectivement dans les deux extrémités de branches 7 et 8 de la partie de cadre en « U » 2B. De même, pour le cadre supérieur de bâti 3, la partie en « U » 3A a ses deux extrémités de branches 9 et 10 enfilées respectivement dans les deux extrémités de branches 11 et 12 de la partie de cadre en « U » 3B. La longueur des traverses télescopiques dépend du degré d'emboîtement des branches et l'on peut régler ainsi la profondeur de la baie. Les moyens pour fixer les traverses télescopiques à une longueur donnée sont ici constitués pour chaque branche d'une goupille 13 adaptée à s'introduire dans deux lumières ménagées dans l'une des deux branches et mises en correspondance. Une série de lumières 14 est prévue sur chaque branche destinée à être emboîtée pour définir des longueurs prédéterminées typiques.

Les montants 4A et 4B ont une forme générale en coupe en deux parties à angle droit de manière à être positionnés et fixés aux quatre angles des cadres inférieur 2 et supérieur 3 du bâti. Les montants 4A et 4B comprennent une bande plane de montant, respectivement 15A, 15B, destinées à s'étendre en façade ou en fond de baie et destinée à servir à la fixation d'une porte en façade de baie ou du fond (parois non représentées sur la figure) et une bande de montant, respectivement 16A, 16B, destinée à se situer dans un plan parallèle aux côtés de la baie, et constituée de deux volets de bande plans formant entre eux une glissière, respectivement 17A, 17B. Deux glissières, telles que 17A, 17B, en vis-à-vis forment les moyens de maintien d'une paroi de côté 18. Celle-ci est en fait constituée de deux panneaux 18A et 18B ayant des parties se chevauchant plus ou moins sur une zone 19, le bord latéral de chaque panneau coopérant avec l'une des glissières. Cette conception avec des panneaux coulissants présente également l'avantage de permettre l'accès latéralement à l'intérieur de la baie simplement en faisant coulisser un panneau sur l'autre en cas de besoin.

De la même manière, le toit de la baie peut être constitué de deux panneaux coulissants montés dans des glissières latérales qui sont fixées avant ou après montage sur la baie.

Il va de soi que des variantes de réalisation sont possibles, notamment à la place de montants munis de glissières pour les panneaux coulissants, on peut prévoir des montants avec des perçages et fixer les panneaux coulissants réglés à la bonne largeur sur ces montants. Cela permet, en cas de besoin de retirer les panneaux latéraux pour accéder latéralement à l'intérieur de la baie.

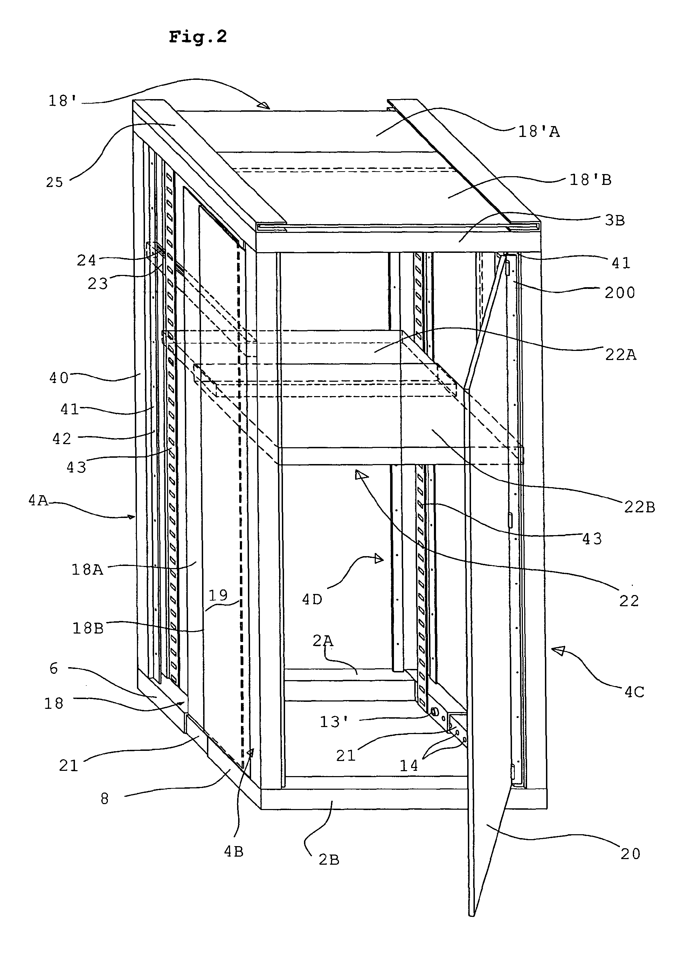

Selon le mode de réalisation illustré en figure 2, les deux cadres inférieur 2A, 2B sont assemblés entre eux par un ou plusieurs éléments intermédiaires, à l'aide de moyens d'assemblage comme des goupilles ou des vis 13'. Il peut s'agir en particulier d'un élément intermédiaire 21 s'emboîtant à ses extrémités dans l'extrémité des branches d'un « U » formés par les deux cadres inférieurs 2A, 2B. Les branches des cadres inférieurs et/ou l'élément intermédiaire portent un jeu de plusieurs lumières 14 définissant un assemblage dans un choix de plusieurs positions, permettant un ajustement de la profondeur du bâti.

Dans ce mode de réalisation, les montants 4A, 4B, 4C, 4D comprennent des moyens de positionnement 41 et/ou des moyens de fixation ou d'accrochage 42 d'une ou plusieurs parois. Une telle paroi peut être une paroi latérale 18, ou une paroi d'extrémité comme un toit 18', ou une paroi comportant au moins une partie mobile et formant une porte 20.

Entre deux quelconque des montants 4A, 4B, 4C, 4D peuvent également être fixés des moyens de guidage d'une paroi ou d'une partie 18A, 18'A de paroi coulissante, permettant une ouverture temporaire pour accéder à l'intérieur de la baie. Ces moyens de guidage peuvent comprendre par exemple une traverse portant une glissière 25 enserrant la partie mobile 18'A ou une traverse 23 coopérant avec la partie mobile par un système de rail 24.

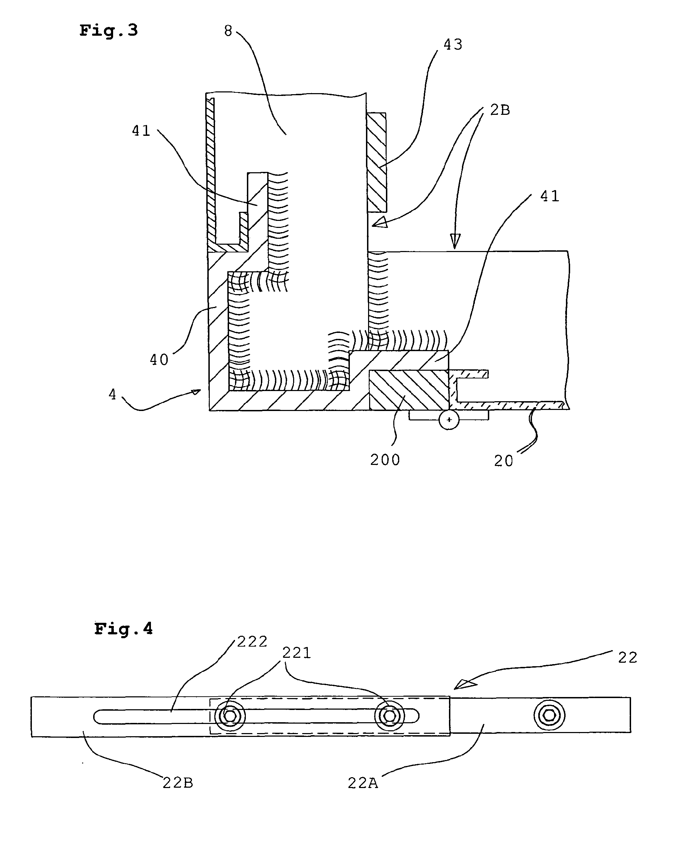

Ainsi qu'illustré en figure 3, les montants 4A comprennent un profilé 40 assemblé à ses extrémités avec le cadre inférieur 2A et le cadre supérieur 3A, par exemple par soudure. Ce profilé porte au moins une bande de montant 41 longitudinale en retrait par rapport à sa surface extérieure. Pour la paroi 18 ou la porte 20 qu'elle reçoit, cette bande de montant 41 détermine une position sensiblement affleurante à la sur face extérieure du profilé 40. Cette bande de montant 41 peut porter des moyens de fixation ou d'accrochage, comme des lumières ou des crochets coopérant avec cette paroi 18 ou avec un support 200 de porte 20.

De façon à présenter un aspect uniforme et esthétique, le cadre 2B masque la section du profilé 40 en recouvrant son extrémité. Dans le même esprit, le cadre et le profilé sont disposés l'un par rapport à l'autre de façon à ce que leurs surfaces extérieures soient affleurantes entre elles. De façon à présenter un aspect dénudé et esthétique, les lumières 14 et les moyens de fixations 13' assemblant entre eux les cadres et les éléments intermédiaires 21 sont disposés sur les surfaces tournées vers l'intérieur de la baie. Dans le même but, les moyens 42 de fixation ou d'accrochage des parois 18 avec les bandes de montant 41 sont situés sur les surfaces de la paroi situées vers l'intérieur de la baie.

Selon une autre variante (non représentée), les profilés recouvrent les angles extérieurs du cadre, en particulier par emboîtement.

Parallèlement aux montants 4A, 4B, 4C, 4D sont fixés des profilés comportant une ou plusieurs séries de lumières formant des échelles d'accrochage 43 sur lesquelles peuvent être accrochés des éléments à installer dans la baie, ou des étagères 22 les supportant. Ces échelles peuvent être en particulier assemblées à leurs extrémités aux cadres inférieurs 2A, 2B et supérieurs 3A, 3B. De préférence, de telles échelles sont fixées sur les faces intérieures des deux branches 5, 6, 7, 8 du « U » formés par les deux cadres inférieurs 2A, 3A et des deux branches 9, 10, 11, 12 du « U » formés par les deux cadres supérieurs 2B, 3B. La baie comprend ainsi deux échelles 43 sur chacun de ses côtés, situées à l'intérieur des parois fermant ces côtés.

Ainsi qu'illustré en figures 2 et 4, la baie selon l'invention inclut au moins une étagère 22 comprenant au moins deux parties mobiles l'une par rapport à l'autre de façon à lui donner une profondeur variable. Cette étagère 22 comprend en particulier deux parties 22A, 22B s'emboîtant l'une dans l'autre de façon télescopique, et pouvant être fixées entre elles par des moyens de fixation, par exemple une vis 222 montée sur une partie 22A et traversant en une position ajustable une rainure portée par l'autre partie 22B pour serrer ensemble ces deux parties.

## Revendications

1. Baie modulable pour matériel informatique, électronique, électrique ou similaire comprenant un bâti (1) parallélépipédique supportant au moins une paroi (18) fermant tout ou partie de ses accès sur au moins une de ses faces, ledit bâti (1) comprenant notamment des traverses (5, 7 ; 6, 8 ; 9, 11 ;10, 12) définissant la profondeur de ladite baie, **caractérisée en ce que** lesdites traverses sont télescopiques comportant des moyens (13, 14) pour les fixer dans une position télescopique choisie définissant pour l'intérieur du bâti une profondeur dépendant de la position de cette traverse.

2. Baie modulable selon la revendication 1, **caractérisée en ce que** chaque traverse télescopique est constituée d'au moins deux barres télescopiques (5, 7 ; 6, 8 ; 9, 11 ;10, 12).

3. Baie modulable selon la revendication 1 ou 2, **caractérisée en ce que** le bâti comprend deux cadres (2, 3) constitués chacun de deux parties en « U » (2A, 2B ; 3A, 3B) dont les branches (5, 7 ; 6, 8 ; 9, 11 ;10, 12) sont adaptées à s'emboîter deux à deux en vis-à-vis pour former lesdites traverses télescopiques.

4. Baie modulable selon l'une des revendications 1 à 3, **caractérisée en ce que** les moyens de fixation en position des traverses télescopiques comprennent un système de lumières placées en correspondance coopérant avec une goupille.

5. Baie modulable selon l'une des revendications 1 à 4, **caractérisée en ce qu'**au moins deux montants de bâti (4A, 4B) comprennent une bande de montant (16A, 16B) en deux volets entre lesquels est formée une glissière (17A, 17B) destinée à coopérer avec un bord d'une paroi (18), deux glissières en vis-à-vis formant ainsi des moyens de maintien de ladite paroi.

6. Baie modulable selon l'une quelconque des revendications 1 à 5, **caractérisée par** au moins une paroi (18) comprenant au moins deux panneaux (18A, 18B) pouvant se chevaucher et formant une paroi de largeur variable.

7. Baie modulable selon quelconque des revendications précédentes, **caractérisé en ce qu'**au moins une des parois présente au moins une partie mobile réalisant une porte (20) fermant un accès en une face de la baie.

8. Baie modulable selon l'une quelconque des revendications précédentes, **caractérisée en ce que** le bâti comprend deux cadres (2, 3) constitués chacun de deux parties en « U » (2A, 2B ; 3A, 3B) dont les branches (5, 7 ; 6, 8 ; 9, 11 ;10, 12) en vis-à-vis sont adaptées à s'emboîter avec au moins un élément intermédiaire (21) les réunissant pour former lesdites traverses télescopiques.

9. Baie modulable selon l'une quelconque des revendications précédentes, **caractérisée en ce qu'**au moins un montant de bâti (4B) comprend une bande de montant (16B, 15B) portant des moyens de fixation ou d'accrochage d'une paroi (18) ou d'une porte (20).

10. Baie modulable selon l'une quelconque des revendications précédentes, **caractérisée en ce qu'**au moins une des parois (18) ou portes (20) masque la majorité des moyens de fixation ou d'accrochage qui la fixent au bâti.

11. Baie modulable selon l'une quelconque des revendications précédentes, **caractérisée en ce qu'**au moins une paroi (18) comprend au moins un panneau (18A) mobile pouvant coulisser sensiblement dans le plan de la paroi pour découvrir un accès à l'intérieur de la baie, grâce à des moyens de guidage (24, 25) portés par au moins une traverse (23, 10, 12).

12. Baie modulable selon l'une quelconque des revendications précédentes, **caractérisée en ce que** des montants de bâti supportent au moins une étagère (22) comprenant au moins deux parties (22A, 22B) pouvant se chevaucher ou s'emboîter et formant une étagère de profondeur variable.
